# EUROPEAN PATENT APPLICATION

(11) **EP 4 353 761 A1**
(43) Date of publication of application: **17.04.2024**
(21) Application number: 22819972.5
(22) Date of filing: 02.05.2022
(51) Int. Cl.: C08F 290/06

(54) **THERMALLY CONDUCTIVE RESIN COMPOSITION AND CURED PRODUCT**

(30) Priority: 11.06.2021 JP 2021097713
(71) Applicant: ThreeBond Co., Ltd., Tokyo 192-0398 (JP)
(72) Inventor: KUWAHARA, Yusuke, Hachioji-shi, Tokyo 192-0398 (JP)
(74) Representative: Petty, Catrin Helen
(86) International application number: PCT/JP2022/019492
(87) International publication number: WO 2022/259786

(57) **Abstract**

An object of the present invention is to provide a thermally conductive resin composition with which a cured product excellent in tensile strength and extensibility while maintaining thermal conductivity can be obtained. The present invention is to provide a thermally conductive resin composition including components (A) to (E) below. Component (A): Urethane (meth)acrylate having a (meth)acryloyl group at one end and having a polyether skeleton, Component (B): Monofunctional (meth)acrylic monomer having a polyether skeleton and not having a urethane skeleton, Component (C): Radical polymerization initiator, Component (D): Plasticizer, Component (E): Thermally conductive powder.

## Description

### TECHNICAL FIELD

The present invention relates to a thermally conductive resin composition and a cured product therefrom.

### BACKGROUND ART

In recent years, for the purpose of dissipating heat generated from electrical and electronic components to the outside, a thermally conductive resin composition has been used between a heating element of electrical and electronic components such as a semiconductor and the like and a heat dissipation member such as a heat dissipation fin and the like. As the thermally conductive resin composition, a thermally conductive resin composition has been frequently used because both adhesiveness and thermal conductivity can be achieved.

JP 2015-212325 A discloses a thermally conductive resin composition containing a polyurethane having a (meth)acryloyl group and a polyoxyalkylene skeleton, a polymerizable monomer containing (meth)acrylic acid, a thermally conductive filler, and a polymerization initiator.

### SUMMARY OF INVENTION

However, in the thermally conductive resin composition as disclosed in JP 2015-212325 A, since a large amount of the thermally conductive filler is added in order to obtain thermal conductivity, a cured product becomes hard and brittle. Therefore, there is a problem that followability with respect to members such as an electrical and electronic component and the like is difficult.

Therefore, the present invention has been made in view of the above circumstances, and an object thereof is to provide a thermally conductive resin composition with which a cured product having excellent tensile strength and extensibility while maintaining thermal conductivity can be obtained.

The gist of the present invention will be described below.
[1] A thermally conductive resin composition including components (A) to (E) below:
   Component (A): Urethane (meth)acrylate having a (meth)acryloyl group at one end and having a polyether skeleton;
   Component (B): Monofunctional (meth)acrylic monomer having a polyether skeleton and having no urethane skeletons;
   Component (C): Radical polymerization initiator;
   Component (D): Plasticizer; and
   Component (E): Thermally conductive powder(s).
[2] A thermally conductive resin composition including an agent A and an agent B below:
   Agent A: Composition containing components (A) to (E) below,
   Component (A): Urethane (meth)acrylate having a (meth)acryloyl group at one end and having a polyether skeleton,
   Component (B): Monofunctional (meth)acrylic monomer having a polyether skeleton and having no urethane skeletons,
   Component (C): Radical polymerization initiator,
   Component (D): Plasticizer, and
   Component (E): Thermally conductive powder; and
   Agent B: Composition containing at least a curing accelerator.
[3] The thermally conductive resin composition according to [1] or [2], in which an addition amount (formulation amount) of the component (A) is in the range of 20 to 90 parts by mass with respect to a total of 100 parts by mass of the component (A) and the component (B).
[4] The thermally conductive resin composition according to any one of [1] to [3], in which an addition amount (formulation amount) of the component (D) is in the range of 10 to 200 parts by mass with respect to a total of 100 parts by mass of the component (A) and the component (B).
[5] The thermally conductive resin composition according to any one of [1] to [4], in which the component (D) is a polyether-based plasticizer.
[6] The thermally conductive resin composition according to any one of [1] to [5], in which the component (E) includes:
   (E1) a thermally conductive powder(s) having an average particle diameter of 0.01 um or larger and smaller than 2.0 um;
   (E2) a thermally conductive powder(s) having an average particle diameter of 2.0 um or larger and smaller than 20 um; and
   (E3) a thermally conductive powder(s) having an average particle diameter of 20 um or larger and smaller than 150 µm.
[7] The thermally conductive resin composition according to [6], in which the component (E) has a mass ratio (E1)/(E3) of 0.08 to 1.00 and a mass ratio (E2)/(E3) of 0.15 to 1.50.
[8] The thermally conductive resin composition according to any one of [1] to [7], in which an elongation percentage of a cured product therefrom is 60% to 1500%.
[9] A cured product obtained from the thermally conductive resin composition according to any one of [1] to [8].
[10] An electronic component that dissipates heat through the thermally conductive resin composition according to any one of [1] to [8] .
[11] A thermally conductive resin composition including components (A"), (B"), (C), and (E) below, in which a tensile strength of a cured product therefrom is 0.40 MPa or more, and an elongation percentage of a cured product therefrom is 60% to 1500%:
   Component (A"): Urethane (meth)acrylate;
   Component (B"): Monofunctional (meth)acrylic monomer having no urethane skeletons;
   Component (C): Radical polymerization initiator; and
   Component (E): Thermally conductive powder.
[12] The thermally conductive resin composition according to [11], in which an addition amount (formulation amount) of the component (A") is in the range of 20 to 90 parts by mass with respect to a total of 100 parts by mass of the component (A") and the component (B").
[13] The thermally conductive resin composition according to [11] or [12], further including a component (D) below.
   Component (D): Plasticizer.
[14] The thermally conductive resin composition according to [13], in which an addition amount (formulation amount) of the component (D) is in the range of 10 to 200 parts by mass with respect to a total of 100 parts by mass of the component (A") and the component (B").
[15] The thermally conductive resin composition according to [13] or [14], in which the component (D) is a polyether-based plasticizer.
[16] The thermally conductive resin composition according to any one of [11] to [15], in which the component (E) includes:
   (E1) a thermally conductive powder(s) having an average particle diameter of 0.01 um or larger and smaller than 2.0 um;
   (E2) a thermally conductive powder(s) having an average particle diameter of 2.0 um or larger and smaller than 20 um; and
   (E3) a thermally conductive powder(s) having an average particle diameter of 20 um or larger and smaller than 150 µm.
[17] The thermally conductive resin composition according to [16], in which the component (E) has a mass ratio (E1)/(E3) of 0.08 to 1.00 and a mass ratio (E2)/(E3) of 0.15 to 1.50.
[18] A cured product obtainable from the thermally conductive resin composition according to any one of [11] to [17].
[19] An electronic component that dissipates heat through the thermally conductive resin composition according to any one of [11] to [17].

### DESCRIPTION OF EMBODIMENTS

According to a first aspect of the present invention, there is provided a thermally conductive resin composition containing components (A) to (E) below.
Component (A): Urethane (meth)acrylate having a (meth)acryloyl group at one end and having a polyether skeleton
Component (B): Monofunctional (meth)acrylic monomer having a polyether skeleton and not having a urethane skeleton
Component (C): Radical polymerization initiator
Component (D): Plasticizer
Component (E): Thermally conductive powder

According to a second aspect of the present invention, there is provided a thermally conductive resin composition containing an agent A and an agent B below.
Agent A: Composition containing components (A) to (E) below.
Component (A): Urethane (meth)acrylate having a (meth)acryloyl group at one end and having a polyether skeleton
Component (B): Monofunctional (meth)acrylic monomer having a polyether skeleton and not having a urethane skeleton
Component (C): Radical polymerization initiator
Component (D): Plasticizer
Component (E): Thermally conductive powder
Agent B: Composition containing at least a curing accelerator.

According to a third aspect of the present invention, there is provided a thermally conductive resin composition containing components (A"), (B"), (C), and (E) below, in which a tensile strength of a cured product therefrom is 0.40 MPa or more, and an elongation percentage of a cured product therefrom is 60% to 1500%.
Component (A"): Urethane (meth)acrylate
Component (B"): Monofunctional (meth)acrylic monomer not having a urethane skeleton
Component (C): Radical polymerization initiator
Component (E): Thermally conductive powder

According to the present invention, a thermally conductive resin composition can be provided, with which thermally conductive resin composition a cured product having excellent tensile strength and extensibility while maintaining thermal conductivity can be obtained.

Hereinafter, the present invention will be described in detail. Please note that the present invention is not limited only to the following, and various modifications can be made within the scope of the appended claims. Throughout the description, unless particularly stated otherwise, any expression in a singular form should be understood to encompass the concept of its plural form. Therefore, unless particularly stated otherwise, the article specifying a single form (for example, "a", "an", "the", and the like in the case of English language) should be understood to encompass the concept of its plural form. Further, unless particularly stated otherwise, any term used in the present description should be understood as a term that is used to have the meaning conventionally used in the relevant technical field. Therefore, unless defined otherwise, all the technical terms and scientific terms used in the present description have the same meaning as generally understood by a person ordinarily skilled in the art to which the present invention is pertained. If there is any conflict in meaning, the present description (including the definitions) takes priority.

In the present description, the expression "X to Y" is used to mean that numerical values (X and Y) stated before and after the "X to Y" are included as a lower limit value and an upper limit value, and means "X or more and Y or less". Also, in the present invention, (meth)acrylate includes both acrylate and methacrylate.

### <Thermally Conductive Resin Composition (First Aspect)>

### <Component (A)>

A component (A) included in the thermally conductive resin composition of the present invention is a urethane (meth)acrylate having a (meth)acryloyl group at one end and having a polyether skeleton. Here, "the component (A) is a urethane (meth)acrylate having a (meth)acryloyl group at one end and having a polyether skeleton" means that the component (A) has the (meth)acryloyl group only at one end, that is, the component (A) is a urethane (meth)acrylate having a (meth)acryloyl group at one end but no (meth)acryloyl group at the other end, and having a polyether skeleton. Therefore, the urethane (meth)acrylate having (meth)acryloyl groups at both ends and having a polyether skeleton is not included in the component (A). The component (A) is not particularly limited as long as it is a urethane (meth)acrylate having a (meth)acryloyl group at one end and having a polyether skeleton, but a cured product having excellent tensile strength and extensibility while maintaining thermal conductivity can be obtained, by being combined with other components of the present invention. The urethane (meth)acrylate is a compound having a (meth)acryloyl group and a urethane bond formed by reacting an isocyanate group with a hydroxy group. The polyether skeleton means, for example, a skeleton having an alkylene oxide such as polyethylene oxide, polypropylene oxide, polybutylene glycol, or the like.

A method for producing the component (A) is not particularly limited, but examples thereof may include a urethane (meth)acrylate formed from a reaction product of a polyol compound having a hydroxyl group and a (meth)acrylate having an isocyanate group, a urethane (meth)acrylate formed from a reaction product of a polyol compound having a hydroxyl group, a polyisocyanate compound, and a (meth)acrylate having a hydroxyl group, and the like. The polyol compound having a hydroxyl group is, for example, polyethylene oxide, polypropylene oxide, or polybutylene glycol, and the number of repetitions of the alkylene oxide is not particularly limited, but is, in the range of, for example, 3 to 500, more preferably 5 to 100, and particularly preferably 10 to 50. In addition, examples of the (meth)acrylate having an isocyanate group may include 2-isocyanatoethyl (meth)acrylate, 2-(2-(meth)acryloyloxyethyloxy)ethyl isocyanate, and the like. The polyisocyanate compound is not particularly limited, but examples thereof may include an aromatic polyisocyanate, an alicyclic polyisocyanate, an aliphatic polyisocyanate, and the like, and among these, aliphatic polyisocyanate and alicyclic polyisocyanate are preferable from the viewpoint of obtaining a flexible cured product. These may be used alone or may also be used in combination of a plurality thereof.

Examples of the aromatic polyisocyanate may include 2,4-tolylene diisocyanate, 2,6-tolylene diisocyanate, 1,3-xylylene diisocyanate, 1,4-xylylene diisocyanate, tetramethylxylylene diisocyanate, diphenylmethane diisocyanate, naphthalene-1,5-disocyanate, triphenylmethane triisocyanate, and the like. Examples of the alicyclic polyisocyanate may include isophorone diisocyanate, bis(4-isocyanatocyclohexyl)methane, 1,3-bis(isocyanatomethyl)cyclohexane, 1,4-bis (isocyanatomethyl)cyclohexane, norbornane diisocyanate, bicycloheptane triisocyanate, and the like. Examples of the aliphatic polyisocyanate may include hexamethylene diisocyanate, 1,3,6-hexamethylene triisocyanate, 1,6,11-undecatriisocyanate, and the like. Examples of the (meth)acrylate having a hydroxyl group may include 2-hydroxyethyl (meth)acrylate, 2-hydroxypropyl (meth)acrylate, 2-hydroxybutyl (meth)acrylate, 4-hydroxycyclohexyl (meth)acrylate, 1,6-hexanediol mono(meth)acrylate, neopentyl glycol mono(meth)acrylate, (poly)ethylene glycol mono(meth)acrylate, (poly)propylene glycol mono(meth)acrylate, pentaerythritol tri(meth)acrylate, and the like. Among these, 2-hydroxyethyl (meth)acrylate, 2-hydroxypropyl (meth)acrylate, 2-hydroxybutyl (meth)acrylate, and 4-hydroxycyclohexyl (meth)acrylate are preferable from the viewpoint of obtaining a cured product excellent in flexibility. These may be used alone or may also be used in combination of a plurality thereof.

Examples of a catalyst used in a synthesis of the component (A) may include lead oleate, antimony trichloride, triphenylaluminum, trioctylaluminum, tetrabutyltin, dibutyltin dilaurate, copper naphthenate, zinc naphthenate, zinc octylate, zinc octenoate, zirconium naphthenate, cobalt naphthenate, tetra-n-butyl-1,3-diacetyloxy distannoxane, triethylamine, 1,4-diaza[2,2,2]bicyclooctane, N-ethylmorpholine, and the like. Among these, dibutyltin dilaurate, zinc naphthenate, zinc octylate, and zinc octenoate are preferably used, from the viewpoint of obtaining a thermally conductive resin composition with which a cured product excellent in tensile strength and extensibility can be obtained. It is preferable that the catalyst (s) is used in an amount of 0.0001 to 10 parts by mass with respect to 100 parts by mass of a total amount of reactants. In addition, regarding a reaction temperature, the reaction is usually performed at 10°C to 100°C, and particularly preferably performed at 30°C to 90°C. In addition, a monofunctional urethane (meth)acrylate can be obtained by sealing excess isocyanate groups at the time of synthesis of the component (A) using a capping agent. Examples of the capping agent may include methanol, ethanol, isopropanol, normal propanol, 1-butanol, 1-heptanol, 1-hexanol, normal octyl alcohol, and the like.

A weight average molecular weight of the component (A) in the present invention is not particularly limited, but the weight average molecular weight is, for example, preferably 3000 to 200000, further preferably 5000 to 100000, and particularly preferably 10000 to 50000 from the viewpoint of obtaining a thermally conductive resin composition with which a cured product excellent in tensile strength and extensibility can be obtained. The weight average molecular weight was calculated by a standard polystyrene conversion method using size exclusion chromatography (SEC) unless otherwise specified.

A commercially available product of the component (A) is not particularly limited, but can be obtained from, for example, Rahn AG, Negami Chemical Industrial Co., Ltd., and the like. Specific examples thereof may include GENOMER 4188, 4312, 4316, 4590, and the like manufactured by Rahn AG.

An addition amount (formulation amount) of the component (A) is preferably in the range of 20 to 90 parts by mass, more preferably 25 to 80 parts by mass, still more preferably 30 to 75 parts by mass, still further preferably 40 to 70 parts by mass, and particularly preferably more than 45 parts by mass and less than 65 parts by mass, with respect to a total of 100 parts by mass of the component (A) and the component (B) to be described later. Within the range, it is possible to provide a thermally conductive resin composition with which a cured product having even more excellent tensile strength and extensibility while further maintaining thermal conductivity can be obtained. In a case where the thermally conductive resin composition includes two or more kinds of the components (A), an addition amount (formulation amount) of the component (A) is a total amount of the component (A) with respect to a total of 100 parts by mass of the component (A) and the component (B).

Alternatively, the addition amount (formulation amount) of the component (A) is preferably in the range of 3 to 15 parts by mass, more preferably 5.0 to 9.0 parts by mass, and particularly preferably more than 5.0 parts by mass and 8.5 parts by mass or less, with respect to a total of 100 parts by mass of the thermally conductive resin composition. Within the range, it is possible to provide a thermally conductive resin composition with which a cured product having even more excellent tensile strength and extensibility while further maintaining thermal conductivity can be obtained. In a case where the thermally conductive resin composition includes two or more kinds of the components (A), an addition amount (formulation amount) of the component (A) is a total amount of the component (A) with respect to a total of 100 parts by mass of the thermally conductive resin composition.

### <Component (B)>

The component (B) included in the thermally conductive resin composition of the present invention is a monofunctional (meth)acrylic monomer having a polyether skeleton but having no urethane skeletons. The component (B) included in the thermally conductive resin composition of the present invention is not particularly limited as long as it is a monofunctional (meth)acrylic monomer having a polyether skeleton and not having a urethane skeleton, but a cured product excellent in tensile strength and extensibility while maintaining thermal conductivity can be obtained, by being combined with other components of the present invention. The polyether skeleton means, for example, a skeleton having an alkylene oxide such as polyethylene oxide, polypropylene oxide, polybutylene glycol, or the like. From the viewpoint of obtaining a thermally conductive resin composition with which a cured product having even more excellent tensile strength and extensibility (particularly extensibility) while further maintaining thermal conductivity can be obtained, it is preferable that the polyether skeleton in the component (B) is a skeleton having polyethylene oxide. The number of repetitions of an alkylene oxide moiety is not particularly limited, but is, for example, 2 to 300, preferably 2 to 9, and more preferably 5 to 9, from the viewpoint of obtaining a thermally conductive resin composition with which a cured product having even more excellent tensile strength and extensibility (particularly extensibility) while further maintaining thermal conductivity can be obtained. The monofunctional (meth)acrylic monomer means a compound having only one (meth)acryloyl group in one molecule.

The component (B) is not particularly limited, but examples thereof may include methoxy diethylene glycol mono(meth)acrylate, methoxy triethylene glycol mono(meth)acrylate, methoxy tetraethylene glycol mono(meth)acrylate, methoxy pentaethylene glycol mono(meth)acrylate, methoxy hexaethylene glycol mono(meth)acrylate, methoxy heptaethylene glycol mono(meth)acrylate, methoxy octaethylene glycol mono(meth)acrylate, methoxy nonaethylene glycol mono(meth)acrylate, methoxy decaethylene glycol mono(meth)acrylate, methoxy tripropylene glycol mono(meth)acrylate, methoxy tetrapropylene glycol mono(meth)acrylate, methoxy pentapropylene glycol mono(meth)acrylate, methoxy hexapropylene glycol mono(meth)acrylate, methoxy heptapropylene glycol mono(meth)acrylate, methoxy octapropylene glycol mono(meth)acrylate, methoxy nonapropylene glycol mono(meth)acrylate, methoxy decapropylene glycol mono(meth)acrylate, methoxy tributylene glycol mono(meth)acrylate, methoxy tetrabutylene glycol mono(meth)acrylate, methoxy pentabutylene glycol mono(meth)acrylate, methoxy hexabutylene glycol mono(meth)acrylate, methoxy heptabutylene glycol mono(meth)acrylate, methoxy octabutylene glycol mono(meth)acrylate, methoxy nonabutylene glycol mono(meth)acrylate, methoxy decabutylene glycol mono(meth)acrylate, ethoxy diethylene glycol mono(meth)acrylate, ethoxy triethylene glycol mono(meth)acrylate, ethoxy tetraethylene glycol mono(meth)acrylate, ethoxy pentaethylene glycol mono(meth)acrylate, ethoxy hexaethylene glycol mono(meth)acrylate, ethoxy heptaethylene glycol mono(meth)acrylate, ethoxy octaethylene glycol mono(meth)acrylate, ethoxy nonaethylene glycol mono(meth)acrylate, ethoxy decaethylene glycol mono(meth)acrylate, ethoxy tripropylene glycol mono(meth)acrylate, ethoxy tetrapropyleneglycol mono(meth)acrylate, ethoxy pentapropylene glycol mono(meth)acrylate, ethoxy hexapropylene glycol mono(meth)acrylate, ethoxy heptapropylene glycol mono(meth)acrylate, ethoxy octapropylene glycol mono(meth)acrylate, ethoxy nonapropylene glycol mono(meth)acrylate, ethoxy decapropylene glycol mono(meth)acrylate, ethoxy tributylene glycol mono(meth)acrylate, ethoxy tetrabutylene glycol mono(meth)acrylate, ethoxy pentabutylene glycol mono(meth)acrylate, ethoxy hexabutylene glycol mono(meth)acrylate, ethoxy heptabutylene glycol mono(meth)acrylate, ethoxy octabutylene glycol mono(meth)acrylate, ethoxy nonabutylene glycol mono(meth)acrylate, ethoxy decabutylene glycol mono(meth)acrylate, and the like. From the viewpoint of obtaining a thermally conductive resin composition with which a cured product having even more excellent tensile strength and extensibility (particularly extensibility) while further maintaining thermal conductivity can be obtained, the component (B) is preferably methoxy diethylene glycol mono(meth)acrylate, methoxy triethylene glycol mono(meth)acrylate, methoxy tetraethylene glycol mono(meth)acrylate, methoxy pentaethylene glycol mono(meth)acrylate, methoxy hexaethylene glycol mono(meth)acrylate, methoxy heptaethylene glycol mono(meth)acrylate, methoxy octaethylene glycol mono(meth)acrylate, methoxy nonaethylene glycol mono(meth)acrylate, ethoxy diethylene glycol mono(meth)acrylate, ethoxy triethylene glycol mono(meth)acrylate, ethoxy tetraethylene glycol mono(meth)acrylate, ethoxy pentaethylene glycol mono(meth)acrylate, ethoxy hexaethylene glycol mono(meth)acrylate, ethoxy heptaethylene glycol mono(meth)acrylate, ethoxy octaethylene glycol mono(meth)acrylate, and ethoxy nonaethylene glycol mono(meth)acrylate, more preferably methoxy diethylene glycol mono(meth)acrylate, methoxy triethylene glycol mono(meth)acrylate, methoxy tetraethylene glycol mono(meth)acrylate, methoxy pentaethylene glycol mono(meth)acrylate, ethoxy diethylene glycol mono(meth)acrylate, ethoxy triethylene glycol mono(meth)acrylate, ethoxy tetraethylene glycol mono(meth)acrylate, and ethoxy pentaethylene glycol mono(meth)acrylate, still more preferably methoxy nonaethylene glycol mono(meth)acrylate and ethoxy diethylene glycol mono(meth)acrylate, and particularly preferably ethoxy diethylene glycol mono(meth)acrylate. These may be used alone or may also be used in combination of a plurality thereof.

An addition amount (formulation amount) of the component (B) preferably satisfies a mixing ratio with the component (A) as defined in the component (A). Within the range, it is possible to provide a thermally conductive resin composition with which a cured product having even more excellent tensile strength and extensibility while further maintaining thermal conductivity can be obtained. In a case where the thermally conductive resin composition includes two or more kinds of the component (B), an addition amount (formulation amount) of the component (B) is a total amount of the component (B) with respect to a total of 100 parts by mass of the component (A) and the component (B).

Alternatively, the addition amount (formulation amount) of the component (B) is preferably in the range of 1 to 10 parts by mass, more preferably 3.0 parts by mass or more and less than 6.5 parts by mass, and particularly preferably 4.0 parts by mass or more and 6.0 parts by mass or less, with respect to a total of 100 parts by mass of the thermally conductive resin composition. Within the range, it is possible to provide a thermally conductive resin composition with which a cured product having even more excellent tensile strength and extensibility while further maintaining thermal conductivity can be obtained. In a case where the thermally conductive resin composition includes two or more kinds of the component (B), an addition amount (formulation amount) of the component (B) is a total amount of the component (B) with respect to a total of 100 parts by mass of the thermally conductive resin composition.

### <Component (C)>

The component (C) that can be used in the present invention is a radical polymerization initiator. Examples of the component (C) may include a photoradical polymerization initiator (hereinafter, also referred to as photoradical initiator), an organic peroxide, and the like. As a curing form of the thermally conductive resin composition of the present invention, photocuring, heat curing, or redox curing can be selected by selecting the component (C) of the present invention. For example, a photoradical polymerization initiator may be selected in a case where it is desired to impart "photocurability" to the thermally conductive resin composition, and an organic peroxide may be selected in a case where it is desired to impart "curing by heating or curing by a redox reaction" to the thermally conductive resin composition. These radical polymerization initiators may be used alone, or a plurality thereof may also be used in combination.

An addition amount (formulation amount) of the component (C) is not particularly limited, but for example, preferably in the range of 0.01 to 20 parts by mass, more preferably 0.1 to 15 parts by mass, still more preferably 0.5 to 10 parts by mass, and particularly preferably more than 2.5 parts by mass and less than 7.0 parts by mass, with respect to a total amount of 100 parts by mass of the component (A) and the component (B). When setting within the range, it is possible to obtain a thermally conductive resin composition with which a cured product even more excellent in tensile strength and extensibility can be obtained. In a case where the thermally conductive resin composition includes two or more kinds of the component (C), an addition amount (formulation amount) of the component (C) is a total amount of the component (C) with respect to a total of 100 parts by mass of the component (A) and the component (B).

Alternatively, the addition amount (formulation amount) of the component (C) is preferably in the range of 0.1 to 5 parts by mass, more preferably 0.2 parts by mass or more and less than 1.0 part by mass, and particularly preferably 0.3 parts by mass or more and 0.8 parts by mass or less, with respect to a total of 100 parts by mass of the thermally conductive resin composition. Within the range, it is possible to provide a thermally conductive resin composition with which a cured product having even more excellent tensile strength and extensibility while further maintaining thermal conductivity can be obtained. In a case where the thermally conductive resin composition includes two or more kinds of the component (C), an addition amount (formulation amount) of the component (C) is a total amount of the component (C) with respect to a total of 100 parts by mass of the thermally conductive resin composition.

The photoradical initiator as the component (C) used in the present invention is not limited as long as it is a compound in which radicals are generated by irradiation with active energy rays. Examples of the component (C) may include an acetophenone-based photoradical initiator, a benzoin-based photoradical initiator, a benzophenone-based photoradical initiator, a thioxanthone-based photoradical initiator, an acylphosphine oxide-based photoradical initiator, a titanocene-based photoradical initiator, and the like. Among these, from the viewpoint of excellent photocurability, acetophenone-based photoradical initiator and acylphosphine oxide-based photoradical initiator are preferable, and acetophenone-based photoradical initiator is particularly preferable. These may be used alone, or two or more kinds thereof may be used in combination.

Examples of the acetophenone-based photoradical initiator may include diethoxy acetophenone, 2-hydroxy-2-methyl-1-phenylpropane-1-one, benzyl dimethyl ketal, 4-(2-hydroxyethoxy)phenyl-(2-hydroxy-2-propyl)ketone, 1-hydroxy-cyclohexyl-phenyl-ketone, 2-methyl-2-morpholino(4-thiomethylphenyl)propane-1-one, 2-benzyl-2-dimethylamino-1-(4-morpholinophenyl)butanone, 2-hydroxy-2-methyl-1-[4-(1-methylvinyl)phenyl]propanone oligomer, and the like, but are not limited thereto. Examples of a commercially available product may include IRGACURE 184 and DAROCUR 1173 (manufactured by BASF), Double Cure 173 (manufactured by DOUBLE BOND CHEMICAL IND. CO., LTD.), and the like.

Examples of the acylphosphine oxide-based photoradical initiator may include bis(2,4,6-trimethylbenzoyl)-phenylphosphine oxide, 2,4,6-trimethylbenzoyl-diphenylphosphine oxide, and the like, but are not limited thereto.

The organic peroxide as the component (C) used in the present invention is a compound in which radical species are generated by heating at 50°C or higher or a redox reaction. Use of the redox reaction is preferable in that the radical species can be generated at room temperature. The component (C) is not particularly limited, and examples thereof may include a ketone peroxide compound such as methyl ethyl ketone peroxide, cyclohexanone peroxide, 3,3,5-trimethylcyclohexanone peroxide, methylcyclohexanone peroxide, methylacetoacetate peroxide, acetylacetone peroxide, and the like; a peroxyketal compound such as 1,1-bis(t-butylperoxy)-3,3,5-trimethylcyclohexane, 1,1-bis(t-butylperoxy)cyclohexane, 2,2-bis(t-butylperoxy)octane, n-butyl-4,4-bis(t-butylperoxy)valerate, 2,2-bis(t-butylperoxy)butane, and the like; a hydroperoxide compound such as t-butyl hydroperoxide, cumene hydroperoxide (cumene hydroperoxide), diisopropyl benzene hydroperoxide, p-menthane hydroperoxide, 2,5-dimethylhexane-2,5-dihydroperoxide, 1,1,3,3-tetramethylbutyl hydroperoxide, and the like; a dialkyl peroxide compound such as di-t-butyl peroxide, t-butylcumyl peroxide, dicumyl peroxide, α,α'-bis(t-butylperoxy-m-isopropyl)benzene, 2,5-dimethyl-2,5-di(t-butylperoxy)hexane, 2,5-dimethyl-2,5-di(t-butylperoxy)hexine-3, and the like; a diacyl peroxide compound such as acetyl peroxide, isobutyryl peroxide, octanoyl peroxide, decanoyl peroxide, lauroyl peroxide, 3,5,5-trimethylhexanoyl peroxide, succinic acid peroxide, benzoyl peroxide, 2,4-dichlorobenzoyl peroxide, m-toluoyl peroxide, and the like; a peroxy dicarbonate compound such as diisopropyl peroxy dicarbonate, di-2-ethylhexyl peroxy dicarbonate, di-n-propyl peroxy dicarbonate, bis-(4-t-butylcyclohexyl) peroxy dicarbonate, dimyristyl peroxy dicarbonate, di-2-ethoxyethyl peroxy dicarbonate, dimethoxyisopropyl peroxy dicarbonate, di(3-methyl-3-methoxybutyl) peroxy dicarbonate, diallyl peroxy dicarbonate, and the like; a peroxy ester compound such as t-butyl peroxy acetate, t-butyl peroxy isobutyrate, t-butyl peroxy pivalate, t-butyl peroxy neodecanoate, t-butyl peroxy-2-ethylhexanoate, cumyl peroxy neodecanoate, t-butyl-2-ethyl peroxy hexanoate, t-butyl peroxy-3,5,5-trimethyl hexanoate, t-butyl peroxy laurate, t-butyl peroxy benzoate, di-t-butyl peroxy isophthalate, 2,5-dimethyl-2,5-di(benzoylperoxy)hexane, t-butyl peroxy maleic acid, t-butyl peroxy isopropyl carbonate, cumyl peroxy octoate, t-hexyl peroxy neodecanoate, t-hexyl peroxy pivalate, t-butyl peroxy neohexanoate, t-hexyl peroxy neohexanoate, cumyl peroxy neohexanoate, and the like; and acetyl cyclohexyl sulfonyl peroxide, t-butylperoxy allyl carbonate, and the like. These organic peroxides may be used alone, or a plurality thereof may also be used in combination. Among these, dialkyl peroxide compound, peroxy dicarbonate compound, and peroxy ester compound are preferably used from the viewpoint of curability. In addition, examples of the organic peroxide suitable for the redox reaction may include a dialkyl peroxide compound.

In a case where an organic peroxide is used as the component (C), a curing accelerator can be incorporated for the purpose of accelerating a redox reaction. In a case where an organic peroxide and a curing accelerator are included as the component (C), the thermally conductive resin composition of the present invention can be used as a one-pack type composition. Such a curing accelerator is not particularly limited, but saccharin (o-benzoic sulfimide), a hydrazine-based compound, an amine compound, a mercaptan compound, a thiourea compound, a metal organic compound, and the like are preferably used. Among these, saccharin (o-benzoic sulfimide), hydrazine-based compound, thiourea compound, and metal organic compound are preferable because a cured product excellent in tensile strength and extensibility can be obtained. The curing accelerator may be used alone, or a plurality thereof may also be used in combination. Using in combination is preferable from the viewpoint of acceleration of curing, and among these, the curing accelerator is preferably combined with the hydrazine-based compound or the thiourea compound and the metal organic compound, and is most preferably combined with the hydrazine-based compound and the metal organic compound.

Examples of the hydrazine-based compound may include 1-acetyl-2-phenyl hydrazine, 1-acetyl-2(p-tolyl) hydrazine, 1-benzoyl-2-phenyl hydrazine, 1-(1',1',1'-trifluoro)acetyl-2-phenyl hydrazine, 1,5-diphenyl-carbohydrazine, 1-formyl-2-phenyl hydrazine, 1-acetyl-2-(p-bromophenyl) hydrazine, 1-acetyl-2-(p-nitrophenyl) hydrazine, 1-acetyl-2-(2'-phenylethyl hydrazine), ethylcarbazate, p-nitrophenyl hydrazine, p-trisulfonyl hydrazide, and the like.

Examples of the amine compound may include a heterocyclic secondary amine such as 2-ethyl hexyl amine, 1,2,3,4-tetrahydroquinone, 1,2,3,4-tetrahydroquinaldine, and the like; a heterocyclic tertiary amine such as quinoline, methyl quinoline, quinaldine, quinoxaline phenazine, and the like; an aromatic tertiary amine such as N,N-dimethyl-para-toluidine, N,N-dimethyl-anisidine, N,N-dimethylaniline, and the like; an azole-based compound such as 1,2,4-triazole, oxazole, oxadiazole, thiadiazole, benzotriazole, hydroxy benzotriazole, benzoxazole, 1,2,3-benzothiadiazole, 3-mercaptobenzotriazole, and the like.

Examples of the mercaptan compound may include n-dodecyl mercaptan, ethyl mercaptan, butyl mercaptan, tris-[(3-mercaptopropionyloxy)-ethyl]-isocyanurate, pentaerythritol tetrakis(3-mercaptopropionate), dipentaerythritol hexakis(3-mercaptopropionate), trimethylolpropane tris(3-mercaptopropionate), trimethylolpropane tristhioglycolate, pentaerythritol tetrakisthioglycolate, and the like.

Examples of the thiourea compound may include ethylene thiourea, diethyl thiourea, tetramethyl thiourea, monoacetyl thiourea, monobenzoyl thiourea, diphenyl thiourea, N,N'-dibutyl thiourea, N,N'-dioctyl thiourea, and the like.

Examples of the metal organic compound may include pentadione iron, pentadione cobalt, cobalt neodecanoate, pentadione copper, propylenediamine copper, ethylenediamine copper, copper neodecanoate, iron naphtate, nickel naphtate, cobalt naphtate, copper naphtate, copper octate, iron hexoate, iron propionate, acetyl acetone vanadium, and the like.

An addition amount (formulation amount) of the curing accelerator is not particularly limited, but for example, it is in the range of 0.001 to 20 parts by mass, more preferably 0.002 to 15 parts by mass, still more preferably 0.003 to 10 parts by mass, and particularly preferably 0.3 to 2.0 parts by mass, with respect to a total of 100 parts by mass of the component (A) and the component (B). Within the range, it is possible to provide a thermally conductive resin composition with which a cured product having even more excellent tensile strength and extensibility while further maintaining thermal conductivity can be obtained. In a case where the thermally conductive resin composition includes two or more kinds of the curing accelerator, an addition amount (formulation amount) of the curing accelerator is a total amount of the curing accelerator with respect to a total of 100 parts by mass of the component (A) and the component (B). Therefore, for example, in a case where the hydrazine-based compound and the metal organic compound are used in combination as the curing accelerator, an addition amount (formulation amount) of the curing accelerator is a total amount of the hydrazine-based compound and the metal organic compound with respect to a total of 100 parts by mass of the component (A) and the component (B).

### <Component (D)>

When combining the plasticizer as the component (D) included in the thermally conductive resin composition of the present invention with the other components of the present invention, it is possible to provide a thermally conductive resin composition with which a cured product having excellent tensile strength and extensibility while maintaining thermal conductivity can be obtained. The component (D) is not particularly limited, but examples thereof may include a polyether-based plasticizer, a (meth)acrylic polymer-based plasticizer, a phthalic acid ester-based plasticizer, a polycarboxylic acid ester-based plasticizer, a polybutadiene-based plasticizer, a polyisoprene-based plasticizer, and the like. Among these, polyether-based plasticizer and (meth)acrylic polymer-based plasticizer are preferable, and polyether-based plasticizer is particularly preferable. The component (D) is a compound which does not have a (meth)acryloyl group. These plasticizers may be used alone, or a plurality thereof may also be used in combination.

The polyether-based plasticizer is a compound having a polyether skeleton. The polyether skeleton means a skeleton having an alkylene oxide such as, for example, polyethylene oxide, polypropylene oxide, polybutylene glycol, or the like, and among these, polypropylene oxide is preferable. The number of repetitions of the alkylene oxide is not particularly limited, but is in the range of, for example, 3 to 300, more preferably 5 to 100, and particularly preferably 10 to 60.

A number average molecular weight of the component (D) is not particularly limited, but is, for example, in the range of 200 to 30000, preferably in the range of 350 to 10000, and particularly preferably in the range of 500 to 5000. The number average molecular weight was calculated by a standard polystyrene conversion method using size exclusion chromatography (SEC) unless otherwise specified. Within the range, it is possible to provide a thermally conductive resin composition with which a cured product having excellent tensile strength and extensibility while maintaining thermal conductivity can be obtained.

A commercially available product of the polyether-based plasticizer of the component (D) is not particularly limited, but examples thereof may include PEG#300, PEG#400, PEG#600, PEG#1000, PEG#1500, PEG#15400, PEG#2000, PEG#4000, PEG#6000, PEG#1100, PEG#2000, UNIOL D-700, D-1000, D-1200, D-2000, D-4000, PB-500, PB-700, PB-1000, PB-2000 (manufactured by NOF Corporation), and the like.

An addition amount (formulation amount) of the component (D) is not particularly limited, but for example, it is 10 to 200 parts by mass, more preferably 15 to 150 parts by mass, and particularly preferably in the range of 20 to 100 parts by mass, with respect to a total of 100 parts by mass of the component (A) and the component (B). Within the range, it is possible to provide a thermally conductive resin composition with which a cured product having even more excellent tensile strength and extensibility while further maintaining thermal conductivity can be obtained. In a case where the thermally conductive resin composition includes two or more kinds of the component (D), an addition amount (formulation amount) of the component (D) is a total amount of the component (D) with respect to a total of 100 parts by mass of the component (A) and the component (B).

Alternatively, the addition amount (formulation amount) of the component (D) is preferably in the range of 1 to 10 parts by mass and more preferably 3 to 5 parts by mass, with respect to a total of 100 parts by mass of the thermally conductive resin composition. Within the range, it is possible to provide a thermally conductive resin composition with which a cured product having even more excellent tensile strength and extensibility while further maintaining thermal conductivity can be obtained. In a case where the thermally conductive resin composition includes two or more kinds of the component (D), an addition amount (formulation amount) of the component (D) is a total amount of the component (D) with respect to a total of 100 parts by mass of the thermally conductive resin composition.

### <Component (E)>

The component (E) of the present invention is not particularly limited as long as it is a thermally conductive powder. The component (E) is preferably a mixture of (E1) a thermally conductive powder having an average particle diameter of 0.01 um or larger and smaller than 2.0 um, (E2) a thermally conductive powder having an average particle diameter of 2.0 um or larger and smaller than 20 um, and (E3) a thermally conductive powder having an average particle diameter of 20 um or larger and smaller than 150 um. That is, in a preferred embodiment of the present invention, the component (E) includes (E1) a thermally conductive powder having an average particle diameter of 0.01 um or larger and smaller than 2.0 um; (E2) a thermally conductive powder having an average particle diameter of 2.0 um or larger and smaller than 20 um; and (E3) a thermally conductive powder having an average particle diameter of 20 um or larger and smaller than 150 um. When the components (E1) to (E3) are used in combination and combined with the other components of the present invention, a remarkable effect of excellent tensile strength and extensibility while maintaining thermal conductivity can be obtained.

An average particle diameter of the component (E1) is preferably 0.01 um or larger and smaller than 2.0 um, more preferably 0.1 um or larger and 1.9 um or smaller, still more preferably 0.2 um or larger and 1.8 um or smaller, and particularly preferably 0.3 um or larger and 1.7 um or smaller, from the viewpoint of excellent tensile strength and extensibility.

An average particle diameter of the component (E2) is preferably 2.0 um or larger and smaller than 20 um (or 2.0 um or larger and smaller than 20.0 µm), more preferably 2.1 um or larger and 15 um or smaller (or 2.1 um or larger and 15.0 um or smaller), still more preferably 2.2 um or larger and 8 um or smaller (or 2.2 um or larger and 8.0 um or smaller), and particularly preferably 2.3 um or larger and 5 um or smaller (or 2.3 um or larger and 5.0 um or smaller), from the viewpoint of excellent tensile strength and extensibility.

An average particle diameter of the component (E3) is preferably 20 um or larger and 150 um or smaller, more preferably 23 um or larger and 100 um or smaller, still more preferably 25 um or larger and 70 um or smaller, and particularly preferably 27 um or larger and smaller than 50 um, from the viewpoint of excellent tensile strength and extensibility while maintaining thermal conductivity.

Here, the average particle diameters of the components (E1) to (E3) are a particle diameter (D50) at a cumulative volume ratio of 50% in a particle size distribution obtained by a laser diffraction scattering method. In the present description, in a case where the components (E1) to (E3) are not spherical, an average of the shortest lengths is taken as the average particle diameter.

In the thermally conductive resin composition of the present invention, a mass ratio ((E1)/(E3)) of the component (E1) to the component (E3) is not particularly limited, but is, for example, 0.08 to 1.00, preferably 0.09 to 0.90, more preferably 0.10 to 0.80, still more preferably 0.11 to 0.70, still further preferably 0.12 to 0.65, and particularly preferably 0.13 to 0.20. Within the range, even more excellent tensile strength and extensibility can be obtained while further maintaining thermal conductivity.

In the thermally conductive resin composition of the present invention, a mass ratio ((E2)/(E3)) of the component (E2) to the component (E3) is not particularly limited, but is, for example, 0.15 to 1.50, preferably 0.17 to 1.20, more preferably 0.18 to 1.00, still more preferably 0.20 to 1.00, still further preferably 0.23 to 0.95, and particularly preferably 0.25 to 0.30. Within the range, even more excellent tensile strength and extensibility can be obtained while further maintaining thermal conductivity.

Therefore, from the viewpoint of excellent tensile strength and extensibility while maintaining thermal conductivity, (E1)/(E3) is 0.08 to 1.0 (or 0.08 to 1.00) and (E2)/(E3) is 0.15 to 1.5 (or 0.15 to 1.50), preferably (E1)/(E3) is 0.09 to 0.9 (or 0.09 to 0.90) and (E2)/(E3) is 0.17 to 1.2 (or 0.17 to 1.20), more preferably (E1)/(E3) is 0.10 to 0.8 (or 0.10 to 0.80) and (E2)/(E3) is 0.18 to 1.0 (or 0.18 to 1.00), still more preferably (E1)/(E3) is 0.11 to 0.70 and (E2)/(E3) is 0.20 to 1.00, still further preferably (E1)/(E3) is 0.12 to 0.65 and (E2)/(E3) is 0.23 to 0.95, and particularly preferably (E1)/(E3) is 0.13 to 0.20 and (E2)/(E3) is 0.25 to 0.30.

An addition amount (formulation amount) of the component (E1) is preferably 5 to 60 parts by mass, more preferably 5 to 30 parts by mass, still more preferably 7 to 28 parts by mass, and particularly preferably 8 to 15 parts by mass, with respect to a total of 100 parts by mass of (E1), (E2), and (E3). An addition amount (formulation amount) of the component (E2) is preferably 10 to 65 parts by mass, more preferably 10 to 50 parts by mass, still more preferably 15 to 40 parts by mass, and particularly preferably more than 15 and less than 25 parts by mass, with respect to a total of 100 parts by mass of (E1), (E2), and (E3). An addition amount (formulation amount) of the component (E3) is preferably 30 to 85 parts by mass, more preferably 30 to 80 parts by mass, still more preferably 40 to 75 parts by mass, and particularly preferably 65 parts by mass or more and less than 75 parts by mass, with respect to a total of 100 parts by mass of (E1), (E2), and (E3). When the addition amounts (formulation amounts) of the components (E1) to (E3) are within the ranges, even more excellent tensile strength and extensibility can be obtained while further maintaining thermal conductivity.

Therefore, as for mixing ratios of the components (E1) to (E3), it is preferable that the component (E1) is 5% to 60% by mass, the component (E2) is 10% to 65% by mass, and the component (E3) is 30% to 85% by mass, it is more preferable that the component (E1) is 5% to 30% by mass, the component (E2) is 10% to 50% by mass, and the component (E3) is 30% to 80% by mass, it is still more preferable that the component (E1) is 7% to 28% by mass, the component (E2) is 15% to 40% by mass, and the component (E3) is 40% to 75% by mass, and it is particularly preferable that the component (E1) is 8% to 15% by mass, the component (E2) is more than 15% by mass and less than 25% by mass, and the component (E3) is 65% by mass or more and less than 75% by mass, in total 100% by mass of (E1), (E2), and (E3). When the mixing ratios of the components (E1) to (E3) are within the ranges, even more excellent tensile strength and extensibility can be obtained while further maintaining thermal conductivity.

From the viewpoint of further improving the effects of the present invention, a content of the component (E1) is, for example, 60 to 400 parts by mass, preferably 70 to 300 parts by mass, more preferably 80 to 250 parts by mass, and particularly preferably more than 80 parts by mass and less than 100 parts by mass, with respect to a total of 100 parts by mass of the component (A) and the component (B). From the same viewpoint, a content of the component (E2) is preferably 110 to 400 parts by mass, more preferably 120 to 350 parts by mass, and particularly preferably 125 parts by mass or more and less than 200 parts by mass, with respect to a total of 100 parts by mass of the component (A) and the component (B). From the same viewpoint, a content of the component (E3) is preferably 400 to 1200 parts by mass, more preferably 450 to 1000 parts by mass, and particularly preferably more than 450 parts by mass and less than 600 parts by mass, with respect to a total of 100 parts by mass of the component (A) and the component (B).

A content of the component (E) (that is, a total content of components (E1) to (E3)) is not particularly limited, but for example, is preferably 55% to 99% by mass, more preferably 70% to 95% by mass, still more preferably 75% to 93% by mass, and particularly preferably 80% to 90% by mass, with respect to the entire (100% by mass) thermally conductive resin composition of the present invention. Within the range, even more excellent tensile strength and extensibility can be obtained while further maintaining thermal conductivity.

It is preferable that the components (E1) to (E3) are each independently a thermally conductive powder of at least one kind selected from the group consisting of alumina, zinc oxide, aluminum nitride, boron nitride, carbon, and diamond, and particularly from the viewpoint of excellent thermal conductivity, it is more preferable that the components (E1) to (E3) are each independently a thermally conductive powder of at least one kind selected from the group consisting of alumina, aluminum nitride, and boron nitride. From the viewpoint of further improving the effect(s) of the present invention, it is preferable that at least one component of the components (E1) to (E3) is alumina, and it is particularly preferable that all of the components (E1) to (E3) are alumina. The component (E) may be surface-treated. These may be used alone or two or more kinds thereof may also be mixed and used.

It is preferable that a shape of the components (E1) to (E3) is preferably spherical or amorphous.

In the present description, the term "spherical" includes not only a perfect spherical shape but also a shape such as a substantially spherical shape, an elliptical shape, and the like. More specifically, the term "spherical" means that an average circularity is 0.4 or more.

In the present description, the term "amorphous" refers to a shape having a corner (for example, acicular, fibrous, scaly, dendritic, plate-like, crushed shape, and the like) other than a spherical shape. More specifically, the term "amorphous" means that an average circularity is less than 0.4.

Furthermore, when the component (E) is a mixture containing a spherical thermally conductive powder and an amorphous thermally conductive powder, a cured product having further improved thermal conductivity can be obtained.

Here, the circularity is a value represented by X/Y in which a perimeter of a circle having a projection area equal to that of a particle projection image acquired using a flow-type particle image analyzer FPIA-3000 (manufactured by Malvern Instruments Ltd.) is X, and a length of a contour line of the particle projection image is Y. Furthermore, the average circularity is calculated by summing the circularity of each particle and dividing the sum by the number of all particles.

From the viewpoint of excellent tensile strength and extensibility, the shape of the component (E1) is preferably spherical. On the other hand, in consideration of thermal conductivity of a cured product, the shape of the component (E1) is preferably amorphous.

From the viewpoint of excellent tensile strength and extensibility, the shape of the component (E2) is preferably spherical. In addition, from the viewpoint of excellent tensile strength and extensibility, the shape of the component (E3) is preferably spherical. Therefore, in an embodiment of the present invention, the components (E2) and (E3) are a spherical thermally conductive powder(s).

In a preferred embodiment of the present invention, the component (E1) is a spherical or amorphous thermally conductive powder, and the components (E2) and (E3) are a spherical thermally conductive powder(s).

In a more preferred embodiment of the present invention, the component (E1) is an amorphous thermally conductive powder, and the components (E2) and (E3) are a spherical thermally conductive powder(s).

A commercially available product of the component (E) is not particularly limited, but can be obtained from, for example, Showa Denko K.K., Nippon Light Metal Co., Ltd., NIPPON STEEL & SUMIKIN MATERIALS CO., LTD., Denka Company Limited, and the like.

### <Optional Component>

An additive such as various elastomers such as a bifunctional or higher polyfunctional (meth)acrylic monomer, a styrene-based copolymer, and the like, a silane coupling agent, an inorganic filler (excluding the component (E)), an organic filler (excluding the component (E)), a flame retardant, a storage stabilizer, an antioxidant, a light stabilizer, a rust inhibitor, a solvent, a pigment, a dye, a tackifier, surfactant, and the like can be used in the thermally conductive resin composition of the present invention, within a range not impairing the object of the present invention.

The polyfunctional (meth)acrylic monomer is not particularly limited as long as it is a bifunctional or higher polyfunctional (meth)acrylic monomer contained in the thermally conductive resin composition of the present invention. Among these, a tetrafunctional or higher functional (meth)acrylic monomer is preferable.

The tetrafunctional or higher functional (meth)acrylic monomer is not particularly limited, but examples thereof may include ditrimethylolpropane tetra(meth)acrylate, pentaerythritol tetra(meth)acrylate, dipentaerythritol monohydroxy penta(meth)acrylate, alkyl-modified dipentaerythritol penta(meth)acrylate, dipentaerythritol hexa(meth)acrylate, and the like. These polymerizable monomers can be used alone or can be used as a mixture of two or more kinds thereof.

The tetrafunctional or higher polyfunctional (meth)acrylic monomer is used preferably in the range of 0.1 to 15 parts by mass, more preferably in the range of 0.2 to 5 parts by mass, and particularly preferably in the range of 0.3 to 3 parts by mass, with respect to a total of 100 parts by mass of the component (A) and the component (B). Within the range, even more excellent tensile strength and extensibility can be attained. In a case where the thermally conductive resin composition contains two or more kinds of tetrafunctional or higher polyfunctional (meth)acrylic monomers, an addition amount (formulation amount) of the tetrafunctional or higher polyfunctional (meth)acrylic monomers is a total amount of the tetrafunctional or higher polyfunctional (meth)acrylic monomers with respect to a total of 100 parts by mass of the component (A) and the component (B).

The inorganic filler is not particularly limited, but examples thereof may include glass, fumed silica, talc, mica, ceramics, a silicone rubber powder, calcium carbonate, aluminum hydroxide, kaolin clay, a dry clay mineral, dry diatomite, and the like, and among these, glass, fumed silica, talc, and mica are preferable.

The fumed silica can be formulated for the purpose of improving mechanical strength of a cured product of the thermally conductive resin composition. Preferably, those hydrophobized with organochlorosilanes, polyorganosiloxanes, hexamethyldisilazane, or the like can be used. Specific examples of the silica may include, for example, a commercially available product such as AEROSIL R974, R972, R972V, R972CF, R805, R812, R812S, R816, R8200, RY200, RX200, RY200S, R202, and the like which are manufactured by Nippon Aerosil Co., Ltd. These may be used alone, or a plurality thereof may also be used in combination.

Examples of the organic filler may include polyethylene, polypropylene, nylon, cross-linked acrylic, cross-linked polystyrene, polyester, polyvinyl alcohol, polyvinyl butyral, and polycarbonate. In addition, examples thereof may include an organic hollow filler and the like such as MMA-AN-MAN copolymerization and the like.

An addition amount of the filler is not particularly limited, but is, for example, in the range of 0.01 to 500 parts by mass, more preferably 0.1 to 300 parts by mass, and particularly preferably in the range of 0.5 to 150 parts by mass, with respect to a total amount of 100 parts by mass of the component (A) and the component (B). These may be used alone, or a plurality thereof may also be used in combination. The addition amount of the filler is intended to be a total amount of the inorganic filler and the organic filler. Therefore, in a case where the thermally conductive resin composition contains two or more kinds of inorganic fillers or two or more kinds of organic fillers or a combination of one or more kinds of inorganic fillers and one or more kinds of organic fillers, the addition amount of the filler is a total amount of the fillers, with respect to a total of 100 parts by mass of the component (A) and the component (B).

Examples of the flame retardant may include aluminum hydroxide, magnesium hydroxide, and the like, and in the present invention, the aluminum hydroxide or the magnesium hydroxide is handled as a flame retardant instead of the component (E) of the invention of the present application.

### <Production Method>

The thermally conductive resin composition of the present invention can be produced by a conventionally known method. For example, the thermally conductive resin composition can be produced by formulating predetermined amounts of the component (A) to component (E) and other optional components and mixing them at a temperature of preferably 10°C to 70°C, more preferably 20°C to 50°C, and particularly preferably normal temperature (25°C) for preferably 0.1 to 5 hours, more preferably 30 minutes to 3 hours, and particularly preferably about 60 minutes, using mixing means such as a mixer such as a planetary mixer or the like. After the mixing, a defoaming treatment may be performed if necessary.

### <Curing Method and Cured Product>

As a curing form of the thermally conductive resin composition of the present invention, photocuring, heat curing, or redox curing can be selected by selecting the component (C) of the present invention. For example, a photoradical polymerization initiator may be selected in a case where it is desired to impart photocurability to the thermally conductive resin composition, and an organic peroxide may be selected in a case where it is desired to impart curing by heating or curing by redox reaction to the thermally conductive resin composition.

Regarding a curing condition in a case of imparting photocurability to the thermally conductive resin composition of the present invention, a light source when curing the thermally conductive resin composition of the present invention by irradiation with light such as ultraviolet rays or visible rays is not particularly limited, and examples thereof may include a low pressure mercury lamp, a medium pressure mercury lamp, a high pressure mercury lamp, an ultra-high pressure mercury lamp, a black light lamp, a microwave excitation mercury lamp, a metal halide lamp, a sodium lamp, a halogen lamp, a xenon lamp, an LED, a fluorescent lamp, sunlight, an electron beam irradiation device, and the like. An irradiation amount of light irradiation is preferably 10 kJ/m² or more, and more preferably 15 kJ/m² or more, from the viewpoint of properties of a cured product. In addition, the curing condition in a case of imparting heat curability to the thermally conductive resin composition of the present invention is not particularly limited, but for example, a temperature is preferably 45°C or higher and lower than 200°C, and more preferably 50°C or higher and lower than 150°C. A curing time is not particularly limited, but is preferably 3 minutes or longer and shorter than 5 hours, and more preferably 10 minutes or longer and 3 hours or shorter, in a case of the temperature of 45°C or higher and lower than 200°C. In addition, the curing condition in the thermally conductive resin composition of the present invention including a curing accelerator is not particularly limited, but for example, a temperature is preferably 10°C or higher and lower than 190°C, and more preferably 20°C or higher and lower than 100°C. A curing time is not particularly limited, but is preferably 24 hours or longer and 100 hours or shorter, and still more preferably 36 hours or longer and 90 hours or shorter. A cured product obtained by curing the thermally conductive resin composition of the present invention is also a part of the embodiment of the present invention. A joined body formed by bonding with the thermally conductive resin composition of the present invention is also a part of an embodiment of the present invention.

That is, the present invention is also to provide a cured product obtained from the thermally conductive resin composition of the present invention. In addition, the present invention is also to provide a joined body formed by bonding with the thermally conductive resin composition of the present invention.

### <Two-Pack Type Composition (Second Aspect)>

The thermally conductive resin composition of the present invention can be used as a one-pack type composition, but can also be used as a two-pack type composition. In a case of the two-pack type composition, it is preferably to be divided into an agent A and an agent B, in which the agent A contains at least the component (C), and the agent B contains at least a curing accelerator. That is, the present invention is also to provide a thermally conductive resin composition containing an agent A and an agent B:
Agent A: Composition containing components (A) to (E) below:
   Component (A): Urethane (meth)acrylate having a (meth)acryloyl group at one end and having a polyether skeleton
   Component (B): Monofunctional (meth)acrylic monomer having a polyether skeleton and not having a urethane skeleton
   Component (C): Radical polymerization initiator
   Component (D): Plasticizer
   Component (E): Thermally conductive powder
Agent B: Composition containing at least a curing accelerator.

As described above, by separating the component (C) and the curing accelerator into separate liquids respectively, unnecessary reaction can be suppressed during storage, and storage stability can be enhanced. Then, the two liquids can be mixed at the time of use, or can be applied separately and then brought into contact with each other to be cured at normal temperature (25°C). Here, components other than the component (C) and the curing accelerator can be divided at a predetermined ratio and contained in either of the liquids.

Examples of the two-pack type composition may include a thermally conductive resin composition comprising an agent A and an agent B below.
Agent A: Composition containing components (A) to (E) below:
   Component (A): Urethane (meth)acrylate having a (meth)acryloyl group at one end and having a polyether skeleton
   Component (B): Monofunctional (meth)acrylic monomer having a polyether skeleton and not having a urethane skeleton
   Component (C): Radical polymerization initiator
   Component (D): Plasticizer
   Component (E): Thermally conductive powder
Agent B: Composition containing at least a curing accelerator, and optionally containing components (A), (B), (D), and (E).

In the above embodiment, as the component (A), the component (B), the component (C) and the curing accelerator, the component (D), and the component (E), the same compounds as those defined in the above <Component (A)>, <Component (B)>, <Component (C)>, <Component (D)>, and <Component (E)>, respectively, can be used. In addition, the same amount as defined above can also be applied as an addition amount (formulation amount) of each component.

In addition, if necessary, the agent A and the agent B can contain an additive(s) defined in the above <Optional Component> in the same manner. In a case where the agent A and the agent B contain an optional component, the same compound as one defined in the above <Optional Component> above can be used as the optional component. In addition, the same amount as defined above can also be applied as an addition amount (formulation amount) of each optional component.

A mixing ratio of the agent A and the agent B is not particularly limited, and is preferably such a ratio that each component has an appropriate amount as described above. Specifically, a mixing ratio of the agent A and the agent B (a mixing mass ratio of agent A: agent B) is preferably 0.1:1 to 10:1, more preferably 0.3:1 to 3:1, and particularly preferably 0.5:1 to 1.5:1. When the mixing ratio is as above, it is possible to provide a thermally conductive resin composition with which a cured product even more excellent in tensile strength and extensibility while further maintaining thermal conductivity can be obtained.

### <Thermally Conductive Resin Composition (Third Aspect)>

According to the present invention, a cured product excellent in tensile strength and extensibility while maintaining thermal conductivity can be obtained. That is, the present invention is to provide a thermally conductive resin composition including components (A"), (B"), (C), and (E) below, which has a tensile strength of a cured product of 0.40 MPa or more, and an elongation percentage of a cured product in the range of 60% to 1500%.
Component (A"): Urethane (meth)acrylate
Component (B"): Monofunctional (meth)acrylic monomer not having a urethane skeleton
Component (C): Radical polymerization initiator
Component (E): Thermally conductive powder

In the aspect, examples of the component (A") may include, in addition to the urethane (meth)acrylate defined in the above <Component (A)>, urethane (meth)acrylate having a polybutadiene skeleton having a (meth)acryloyl group at both ends, urethane (meth)acrylate having a hydrogenated polybutadiene skeleton having a (meth)acryloyl group at both ends, urethane (meth)acrylate having a polycarbonate skeleton having a (meth)acryloyl group at both ends, urethane (meth)acrylate having a polyether skeleton having a (meth)acryloyl group at both ends, urethane (meth)acrylate having a polyester skeleton having a (meth)acryloyl group at both ends, urethane (meth)acrylate having a castor oil skeleton having a (meth)acryloyl group at both ends, urethane (meth)acrylate having a polybutadiene skeleton having a (meth)acryloyl group at one end, urethane (meth)acrylate having a hydrogenated polybutadiene skeleton having a (meth)acryloyl group at one end, urethane (meth)acrylate having a polycarbonate skeleton having a (meth)acryloyl group at one end, urethane (meth)acrylate having a polyester skeleton having a (meth)acryloyl group at one end, urethane (meth)acrylate having a castor oil skeleton having a (meth)acryloyl group at one end, and the like. Among these, urethane (meth)acrylate having a polyether skeleton and having a (meth)acryloyl group at one end defined in the above <Component (A)> is preferably used. Thereby, it is possible to provide a thermally conductive resin composition with which a cured product having even more excellent tensile strength and extensibility while further maintaining thermal conductivity can be obtained. In addition, regarding an addition amount (formulation amount) of the component (A"), the same amount can be applied by replacing the component (A) with the component (A") in the above <Component (A)>.

In the above aspect, examples of the component (B") may include, in addition to the monofunctional (meth) acrylic monomer defined in the above <Component (B) >, ethyl (meth)acrylate, n-butyl (meth)acrylate, ter-butyl (meth)acrylate, isobutyl methacrylate, 2-ethylhexyl (meth)acrylate, isodecyl (meth)acrylate, glycidyl (meth)acrylate, lauryl (meth)acrylate, stearyl (meth)acrylate, tetrahydrofurfuryl (meth)acrylate, cyclohexyl (meth)acrylate, dicyclopentanyl (meth)acrylate, dicyclopentenyl (meth)acrylate, dicyclopentenyloxy (meth)acrylate, isobornyl (meth)acrylate, adamantyl (meth)acrylate, benzyl (meth)acrylate, phenyl (meth)acrylate, phenoxyethyl (meth)acrylate, nonylphenoxyethyl (meth)acrylate, butoxyethyl (meth)acrylate, 2-hydroxyethyl (meth)acrylate, 2-hydroxypropyl (meth)acrylate, 4-hydroxybutyl (meth)acrylate, trifluoroethyl (meth)acrylate, methacryloxyethyl acid phosphate, 2-hydroxyethyl methacrylate phosphate, γ-methacryloxypropyl trimethoxysilane, γ-acryloxypropyl trimethoxysilane, acryloylmorpholine, morpholinoethyl (meth)acrylate, dimethylaminoethyl (meth)acrylate, diethylaminoethyl (meth)acrylate, N,N-dimethyl aminoethyl (meth)acrylate, N,N-dimethyl aminopropyl (meth)acrylate, 3-methacryloxypropyl methyldimethoxysilane, 3-methacryloxypropyl trimethoxysilane, 3-methacryloxypropyl methyldiethoxysilane, 3-methacryloxypropyl triethoxysilane, 3-acryloxypropyl trimethoxysilane, methacryloxyoctyl trimethoxysilane, neopentyl glycol di(meth)acrylate, stearic acid-modified pentaerythritol di(meth)acrylate, dicyclopentenyl diacrylate, di(meth)acryloyl isocyanurate, trimethylolpropane tri(meth)acrylate, pentaerythritol tri(meth)acrylate, ditrimethylolpropane tetra(meth)acrylate, pentaerythritol tetra(meth)acrylate, dipentaerythritol monohydroxypenta(meth)acrylate, alkyl-modified dipentaerythritol pentaacrylate, dipentaerythritol hexa(meth)acrylate, and the like. Among these, a monofunctional (meth)acrylic monomer having the polyether skeleton and not having a urethane skeleton defined in the above <Component (B)> is preferably used. By this, it is possible to provide a thermally conductive resin composition w a cured product having even more excellent tensile strength and extensibility while further maintaining thermal conductivity can be obtained. In addition, regarding an addition amount (formulation amount) of the component (B"), the same amount can be applied by replacing the component (B) with the component (B") in the above <Component (B)>.

In the above aspect, as the component (C) and the component (E), the same compounds as those defined in the above <Component (C)> and <Component (E)> can be used, respectively. In addition, regarding addition amounts (formulation amounts) of the component (C) and the component (E), the same amounts as those defined in the above <Component (C)> and <Component (E)> can be applied, respectively.

The thermally conductive resin composition according to the above aspect may include a plasticizer in addition to the components (A"), (B"), (C), and (E). In a case where the thermally conductive resin composition according to the above aspect includes a plasticizer, the same compound as defined in the above <Component (D)> can be used as the plasticizer. In addition, the same amount as defined in the above <Component (D)> can also be applied as an addition amount (formulation amount) of the plasticizer in this case.

The thermally conductive resin composition according to the above aspect may include another additive(s) in addition to or in place of the plasticizer. In a case where the thermally conductive resin composition according to the above aspect includes another additive(s), the same compound as defined in the above <Optional Component> can be used as the another additive(s). In addition, the same amount as defined in the above <Optional Component> can also be applied as an addition amount (formulation amount) of the another additive(s) in this case.

An elongation percentage of the cured product of the thermally conductive resin composition of the present invention is preferably 60% to 15000, more preferably 650 to 10000, still more preferably 70% to 500%, and particularly preferably 80% to 500% from the viewpoint of high extensibility. A method for measuring the elongation percentage of the cured product is, for example, as follows.

### · Method for Measuring Elongation Percentage of Cured Product

A thermally conductive resin composition is set so as to have a thickness (thickness after curing) of 1 mm, heated and cured at 120°C for 20 minutes, to prepare a sheet-shaped cured product. A test piece is prepared by punching it with a No. 3 dumbbell, and marked lines at intervals of 20 mm are drawn on the test piece. Both ends of the test piece are fixed to a chuck such that a long axis of the test piece and the center of the chuck are in a straight line, and the test piece is pulled at a tensile speed of 500 mm/min until the test piece is cut. At the time of measurement, since the test piece extends and a distance between the marked lines increases, a distance between the marked lines is measured with a caliper until the test piece is cut. A percentage of elongation of the distance based on the initial marked line interval is defined as an "elongation percentage (%)".

A tensile strength of the cured product of the thermally conductive resin composition of the present invention is preferably 0.40 MPa or more, more preferably 0.50 MPa or more, and particularly preferably 0.60 MPa or more, from the viewpoint of high strength. A method for measuring the tensile strength of the cured product is, for example, as follows.

### . Method for Measuring Tensile Strength of Cured Product

The tensile strength of the cured product is in accordance with JIS K6251 (2010). Specifically, a thermally conductive resin composition was set so as to have a thickness (thickness after curing) of 1 mm, heated and cured at 120°C for 20 minutes, and cured to prepare a sheet-shaped cured product. A test piece was produced by punching it with a No. 3 dumbbell. Both ends of the test piece are fixed to a chuck such that a long axis of the test piece and a center of the chuck are in a straight line. The test piece is pulled with a universal testing machine (Tensilon manufactured by ORIENTEC CORPORATION) at a tensile speed of 500 mm/min, and the maximum load is measured. A strength at the maximum load is referred to as "tensile strength (MPa)".

In addition, the cured product of the thermally conductive resin composition of the present invention can maintain high thermal conductivity. Specifically, a thermal conductivity of the cured product is preferably 1.5 W/m-k or higher, more preferably 1.9 W/m-k or higher, and particularly preferably 2.0 W/m-k or higher. A method for measuring the thermal conductivity of the cured product is, for example, as follows.

### · Method for Measuring Thermal Conductivity of Cured Product

A thermally conductive resin composition is applied so as to have a thickness of 500 µm, and heated at 120°C for 20 minutes to prepare a test piece. In the measurement of the thermal conductivity, a thermal diffusivity is measured at 25°C using an ai-Phase Mobile 1 u thermal diffusivity/thermal conductivity measuring apparatus manufactured by I-phase Inc.

### <Application Method>

As a method for applying the thermally conductive resin composition of the present invention to a base material, a known a method for applying an adhesive or coating material can be used. For example, a method such as dispensing using an automatic coater, spraying, inkjet, screen printing, gravure printing, dipping, spin coating, and the like can be used.

### <Use>

The thermally conductive resin composition of the present invention can be used in various fields such as an automobile field, an electrical and electronic component field, an aerospace field, and the like, but since a cured product excellent in tensile strength and extensibility while maintaining conductivity (particularly thermal conductivity) can be obtained, the thermally conductive resin composition can be used for various uses such as: heat dissipation of an electronic board; heat dissipation of an electronic device such as a mobile phone and a computer; heat dissipation of lighting such as an LED; heat dissipation of an optical pickup module; heat dissipation of a camera module; heat dissipation of a sensing device; heat dissipation of a power semiconductor; heat dissipation of an inverter for a hybrid vehicle, a fuel cell vehicle, or an electric vehicle; heat dissipation of a converter for hybrid vehicles, fuel cell vehicles, and electric vehicles; heat dissipation of a battery pack, an ECU component for a hybrid vehicle, a fuel cell vehicle, or an electric vehicle; and the like.

### <Heat Dissipation Method>

The cured product of the thermally conductive resin composition of the present invention can exhibit and maintain high thermal conductivity. Therefore, examples of heat dissipation method using the thermally conductive resin composition of the present invention may include a method or the like in which the thermally conductive resin composition according to an aspect of the present invention is applied to an electronic component or an electrical and electronic component to dissipate heat generated from the electronic component or the electrical and electronic component to the outside. Examples of the electrical and electronic component may include an electronic substrate; a mobile phone; an electronic device such as a personal computer; a lighting device such as an LED; an optical pickup module; a camera module; a sensing device; a power semiconductor; an inverter for an HEV, an FCV, or an EV; a converter for an HEV, an FCV, or an EV; an ECU component for an HEV, an FCV, or an EV; and the like.

That is, the present invention is also to provide an electronic component or an electrical and electronic component characterized in that heat is dissipated through the thermally conductive resin composition.

### [Examples]

Hereinafter, the present invention will be described in more detail with reference to Examples, but the present invention is not limited to these Examples.

### <Preparation of Thermally Conductive Resin Composition>

### Examples 1 to 5 and Comparative Examples 1 to 6

Each component was weighed in parts by mass shown in Table 1, mixed with a mixer at normal temperature (25°C) for 60 minutes under light shielding, and then defoamed to obtain a thermally conductive resin composition. The detailed addition amount is in accordance with Table 1, and all numerical values are expressed in parts by mass. The components in Table 1 are as follows.

<Component (A)>
   a1: Polyether-based urethane acrylate having a weight average molecular weight of 21000 and having an acryloyl group at one end (manufactured by Negami Chemical Industrial Co., Ltd.)
   a2: Polyether-based urethane acrylate having a weight average molecular weight of 30000 and having an acryloyl group at one end (manufactured by Negami Chemical Industrial Co., Ltd.)
<Comparative Component of Component (A)>
   a'1: Polyether-based urethane acrylate having a weight average molecular weight of 40000 and having an acryloyl group at both ends (Shikoh UV-3700B manufactured by Mitsubishi Chemical Corporation)
   a'2: Poly(meth)acrylic polymer having a weight average molecular weight of 24000 and having an acryloyl group at both ends (RC-100C manufactured by KANEKA CORPORATION)
<Component (B)>
   b1: Ethoxydiethylene glycol monoacrylate (LIGHT ACRYLATE EC-A manufactured by Kyoeisha Chemical Co., Ltd.)
   b2: Methoxynonaethylene glycol monoacrylate (AM-90G manufactured by Shin-Nakamura Chemical Co., Ltd.)
<Comparative Component of Component (B)>
   b'1: Isobornyl acrylate (IBXA manufactured by OSAKA ORGANIC CHEMICAL INDUSTRY LTD.)
   b'2: Phenoxyethyl acrylate (LIGHT ACRYLATE PO-A manufactured by Kyoeisha Chemical Co., Ltd.)
   b'3: Isononyl acrylate (INAA manufactured by OSAKA ORGANIC CHEMICAL INDUSTRY LTD.)
<Component (C)>
   c1: t-Butylperoxy-2-ethylhexanoate (PERBUTYL O manufactured by NOF Corporation)
   c2: 2-Hydroxy-2-methyl-1-phenyl-propane-1-one (Double Cure 173 manufactured by DOUBLE BOND CHEMICAL IND.CO., LTD.)
<Component (D)>
   d1: Polypropylene glycol having a number average molecular weight of 2000 in which the number of repetitions of the alkylene oxide is 34 (UNIOL D-2000 manufactured by NOF CORPORATION)
<Component (E)>
   e1: Amorphous alumina powder having an average particle diameter of 0.5 um (manufactured by Nippon Light Metal Co., Ltd.)
   e2: Spherical alumina powder having an average particle diameter of 3.0 µm (manufactured by NIPPON STEEL & SUMIKIN MATERIALS CO., LTD.)
   e3: Spherical alumina powder having an average particle diameter of 35.0 µm (manufactured by NIPPON STEEL & SUMIKIN MATERIALS CO., LTD.)

Test methods of the tests (1) to (3) used in Examples and Comparative Examples in Table 1 are as follows.

### <(1) Measurement of Thermal Conductivity>

Each of the thermally conductive resin compositions in Table 1 was applied so as to have a thickness of 500 um, and heated at 120°C for 20 minutes, to prepare a test piece. In the measurement of the thermal conductivity, a thermal diffusivity was measured at 25°C using an ai-Phase Mobile 1 u thermal diffusivity/thermal conductivity measuring apparatus manufactured by I-phase Inc. The higher the thermal conductivity, the more easily heat is transferred, which is preferable. In particular, in the present invention, 1.5 W/m-k or higher is preferable, 1.9 W/m-k or higher is more preferable, and 2.0 W/m-k or higher is particularly preferable.

### <(2) Measurement of Tensile Strength of Cured Product>

Each of the thermally conductive resin compositions in Table 1 was set so as to have a thickness (thickness after curing) of 1 mm, heated and cured at 120°C for 20 minutes, to prepare a sheet-shaped cured product. A test piece was produced by punching it with a No. 3 dumbbell. Both ends of the test piece were fixed to a chuck such that a long axis of the test piece and a center of the chuck are in a straight line. The test piece was pulled with a universal testing machine (Tensilon manufactured by ORIENTEC CORPORATION) at a tensile speed of 500 mm/min, and the maximum load was measured. A strength at the maximum load was set as "tensile strength (MPa)". The results are shown in Table 1. Details are in accordance with JIS K 6251 (2010). From the viewpoint of high strength in the present invention, the tensile strength is preferably 0.40 MPa or more, more preferably 0.50 MPa or more, and particularly preferably 0.60 MPa or more.

### <(3) Method for Measuring Elongation Percentage of Cured Product>

Each of the thermally conductive resin compositions in Table 1 was set so as to have a thickness (thickness after curing) of 1 mm, heated and cured at 120°C for 20 minutes, to prepare a sheet-shaped cured product. A test piece was prepared by punching it with a No. 3 dumbbell, and marked lines at intervals of 20 mm were drawn on the test piece. The test piece was fixed to a chuck in the same manner as in the measurement of the tensile strength, and pulled with a universal testing machine (Tensilon manufactured by ORIENTEC CORPORATION) at a tensile speed of 500 mm/min until the test piece is cut. At the time of measurement, since the test piece elongated and a distance between the marked lines increased, a distance between the marked lines was measured with a caliper when the test piece was cut. An elongation percentage of the distance based on the initial marked line interval was defined as an "elongation percentage (%)". An evaluation is performed based on the following criteria, and the results are shown in Table 1. Note that, from the viewpoint of high extensibility, the elongation percentage is preferably 60% to 1500%, more preferably 65% to 1000%, still more preferably 70% to 500%, and particularly preferably 80% to 500%.

**[Table 1]**

| | Example 1 | Example 2 | Example 3 | Example 4 | Example 5 | Comparative Example 1 | Comparative Example 2 | Comparative Example 3 | Comparative Example 4 | Comparative Example 5 | Comparative Example 6 |
|---|---|---|---|---|---|---|---|---|---|---|---|
| a1 | 55 | | 55 | 45 | 55 | 70 | | | 55 | 55 | 55 |
| a2 | | 55 | | | | | | | | | |
| a'1 | | | | | | | 55 | | | | |
| a'2 | | | | | | | | 55 | | | |
| b1 | 35 | 35 | | 45 | 35 | 50 | 35 | 35 | | | |
| b2 | | | 35 | | | | | | | | |
| b'1 | | | | | | | | | 35 | | |
| b'2 | | | | | | | | | | 35 | |
| b'3 | | | | | | | | | | | 35 |
| c1 | 3 | 3 | 3 | 3 | 3 | 3 | 3 | 3 | 3 | 3 | 3 |
| c2 | | | | 3 | | | | | | | |
| d1 | 30 | 30 | 30 | 30 | 30 | | 30 | 30 | 30 | 30 | 30 |
| e1 | 80 | 80 | 80 | 80 | 55 | 80 | 80 | 80 | 80 | 80 | 80 |
| e2 | 120 | 120 | 120 | 120 | 120 | 120 | 120 | 120 | 120 | 120 | 120 |
| e3 | 440 | 440 | 440 | 440 | 440 | 440 | 440 | 440 | 440 | 440 | 440 |
| (E1)/(E3) | 0.18 | 0.18 | 0.18 | 0.18 | 0.13 | 0.18 | 0.18 | 0.18 | 0.18 | 0.18 | 0.18 |
| (E2)/(E3) | 0.27 | 0.27 | 0.27 | 0.27 | 0.27 | 0.27 | 0.27 | 0.27 | 0.27 | 0.27 | 0.27 |
| (E1)/(E1) to (E3) | 13% by mass | 13% by mass | 13% by mass | 13% by mass | 9% by mass | 13% by mass | 13% by mass | 13% by mass | 13% by mass | 13% by mass | 13% by mass |
| (E2)/(E1) to (E3) | 19% by mass | 19% by mass | 19% by mass | 19% by mass | 20% by mass | 19% by mass | 19% by mass | 19% by mass | 19% by mass | 19% by mass | 19% by mass |
| (E3)/(E1) to (E3) | 69% by mass | 69% by mass | 69% by mass | 69% by mass | 72% by mass | 69% by mass | 69% by mass | 69% by mass | 69% by mass | 69% by mass | 69% by mass |
| Total content ratio of Components (E1) to (E3) with respect to entire composition | 84% by mass | 84% by mass | 84% by mass | 84% by mass | 83% by mass | 84% by mass | 84% by mass | 84% by mass | 84% by mass | 84% by mass | 84% by mass |
| (1) Thermal conductivity | 2.1 | 2.0 | 2.0 | 2.0 | 1.9 | 2.2 | 1.8 | 2.2 | 1.9 | 2.2 | 1.9 |
| (2) Tensile strength of cured product | 0.50 | 0.60 | 0.51 | 0.67 | 0.55 | 0.70 | 0.53 | 0.52 | 0.49 | 0.39 | 0.30 |
| (3) Elongation Percentage of cured product | 100 | 80 | 115 | 85 | 110 | 50 | 50 | 45 | 25 | 70 | 155 |

As shown in Example 1 to 5 in Table 1, it was confirmed that the present invention could provide a thermally conductive resin composition with which a cured product showing excellent tensile strength and extensibility while maintaining thermal conductivity could be obtained.

It can be noted that with a thermally conductive resin composition of Comparative Example 1 in Table 1 which does not contain the component (D) of the present invention, a cured product has poor extensibility. In addition, it can be noted that with thermally conductive resin compositions of Comparative Examples 2 and 3 using the components a'1 and a'2 which are not the component (A) of the present invention, cured products have poor extensibility. In addition, it can be noted that with thermally conductive resin compositions of Comparative Examples 4 to 6 using the components b'1 to b'3 which are not the component (B) of the present invention, a cured product in Comparative Example 4 has poor extensibility, and cured products in Comparative Examples 5 and 6 have poor tensile strength.

Furthermore, as described below, the thermally conductive resin composition was examined as a two-component composition.

### <Preparation of Agent A and Agent B of Thermally Conductive Resin Composition of Example 6>

### • Agent A

55 parts by mass of the component a1 as the component (A), 35 parts by mass of the component b1 as the component (B), 30 parts by mass of the component d1 as the component (D), 1 part by mass of cumene hydroperoxide which is (c3) as the component (C), and 80 parts by mass of the component e1, 120 parts by mass of the component e2, and 440 parts by mass of the component e3 as the component (E) were added, and mixed with a mixer at normal temperature (25°C) for 60 minutes to obtain an agent A.

### · Agent B

55 parts by mass of the component a1 as the component (A), 35 parts by mass of the component b1 as the component (B), 30 parts by mass of the component d1 as the component (D), 1 part by mass of 1-acetyl-2-phenylhydrazine (reagent manufactured by Aldrich) and 0.1 part by mass of copper neodecanoate (manufactured by Central Chemical Industry Co., Ltd.) having an active component ratio of 5% by mass as a curing accelerator, and 80 parts by mass of the component e1, 120 parts by mass of the component e2, and 440 parts by mass of the component e3 as the component (E) were added, and mixed with a mixer at normal temperature (25°C) for 60 minutes to obtain an agent B.

### <Preparation of Agent A' and Agent B' of Thermally Conductive Resin Composition of Comparative Example 7>

### • Agent A'

55 parts by mass of the component a'1 as a comparative component to the component (A), 35 parts by mass of the component b1 as the component (B), 30 parts by mass of the component d1 as the component (D), 1 part by mass of cumene hydroperoxide which is (c3) as the component (C), and 80 parts by mass of the component e1, 120 parts by mass of the component e2, and 440 parts by mass of the component e3 as the component (E) were added, and mixed with a mixer at normal temperature (25°C) for 60 minutes to obtain an agent A'.

### · Agent B'

55 parts by mass of the component a'1 as a comparative component to the component (A), 35 parts by mass of the component b1 as the component (B), 30 parts by mass of the component d1 as the component (D), 1 part by mass of 1-acetyl-2-phenylhydrazine (reagent) and 0.1 part by mass of copper neodecanoate (manufactured by Central Chemical Industry Co., Ltd.) having an active component ratio of 5% by mass as a curing accelerator, and 80 parts by mass of the component e1, 120 parts by mass of the component e2, and 440 parts by mass of the component e3 as the component (E) were added, and mixed with a mixer at normal temperature (25°C) for 60 minutes to obtain an agent B'.

### <(4) Measurement of Thermal Conductivity>

100 parts by mass of the agent A and 100 parts by mass of the agent B of each of the thermally conductive resin compositions of Example 6 and Comparative Example 7 were put into a polyethylene container, mixed for 10 minutes using a wooden bar under an environment of 25°C, and then defoamed. Subsequently, application was performed so as to have a thickness of 500 um, and curing was performed for 72 hours in an atmosphere of 25°C to prepare a test piece. In the measurement of the thermal conductivity, a thermal diffusivity was measured at 25°C using an ai-Phase Mobile 1 u thermal diffusivity/thermal conductivity measuring apparatus manufactured by I-phase Inc.

The result of Example 6 was 2.0 W/m-k, while the result of Comparative Example 7 was 1.9 W/m-k. Note that, the larger the thermal conductivity, the more easily heat is transferred, which is preferable. In particular, in the present invention, 1.5 W/m-k or more is preferable.

### <(5) Measurement of Tensile Strength of Cured Product>

100 parts by mass of the agent A and 100 parts by mass of the agent B of each of the thermally conductive resin compositions of Example 6 and Comparative Example 7 were put into a polyethylene container, mixed for 10 minutes using a wooden bar under an environment of 25°C, and then defoamed. Subsequently, it was set so as to have a thickness (thickness after curing) of 1 mm, and cured for 72 hours under an atmosphere of 25°C, to prepare a sheet-shaped cured product. A test piece was produced by punching it with a No. 3 dumbbell. Both ends of the test piece were fixed to a chuck such that a long axis of the test piece and a center of the chuck are in a straight line. The test piece was pulled with a universal testing machine (Tensilon manufactured by ORIENTEC CORPORATION) at a tensile speed of 500 mm/min, and the maximum load was measured. A strength at the maximum load was set as "tensile strength (MPa)". Details are in accordance with JIS K 6251 (2010).

The result of Example 6 was 0.63 MPa, while the result of Comparative Example 7 was 0.90 MPa. From the viewpoint of high strength in the present invention, the tensile strength is preferably 0.40 MPa or more, more preferably 0.50 MPa or more, and particularly preferably 0.60 MPa or more.

### <(6) Method for Measuring Elongation Percentage of Cured Product>

100 parts by mass of the agent A and 100 parts by mass of the agent B of each of the thermally conductive resin compositions of Example 6 and Comparative Example 7 were put into a polyethylene container, and mixed for 10 minutes using a wooden bar under an environment of 25°C. Subsequently, it was set so as to have a thickness (thickness after curing) of 1 mm, and cured for 72 hours under an atmosphere of 25°C, to prepare a sheet-shaped cured product. A test piece was prepared by punching it with a No. 3 dumbbell, and marked lines at intervals of 20 mm were drawn on the test piece.

The test piece was fixed to a chuck in the same manner as in the measurement of the tensile strength, and pulled with a universal testing machine (Tensilon manufactured by ORIENTEC CORPORATION) at a tensile speed of 500 mm/min until the test piece was cut. At the time of measurement, since the test piece elongated and a distance between the marked lines increased, a distance between the marked lines was measured with a caliper when the test piece was cut. A percentage of elongation of the distance based on the initial marked line interval was defined as an "elongation percentage (%)".

The result of Example 6 was 70%, while the result of Comparative Example 7 was 40%. Note that, from the viewpoint of high extensibility, the elongation percentage is preferably 60% or higher, more preferably 65% or higher, and particularly preferably 70% or higher.

### Industrial Applicability

The present invention is to provide a thermally conductive resin composition with which a cured product excellent in tensile strength and extensibility with thermal conductivity maintained can be obtained, and thus can be used in various fields and is industrially useful.

The present application is based on Japanese Patent Application No. 2021-097713 filed on June 11, 2021, the disclosure content of which is incorporated herein by reference in entirety thereof.

## Claims

1. A thermally conductive resin composition comprising components (A) to (E) below:
component (A): urethane (meth)acrylate having a (meth)acryloyl group at one end and having a polyether skeleton;
component (B): a monofunctional (meth)acrylic monomer having a polyether skeleton and not having a urethane skeleton;
component (C): a radical polymerization initiator;
component (D): a plasticizer; and
component (E): a thermally conductive powder.

2. A thermally conductive resin composition comprising an agent A and an agent B below:
agent A: a composition containing components (A) to (E) below,
component (A): urethane (meth)acrylate having a (meth)acryloyl group at one end and having a polyether skeleton,
component (B): a monofunctional (meth)acrylic monomer having a polyether skeleton and not having a urethane skeleton,
component (C): a radical polymerization initiator,
component (D): a plasticizer, and
component (E): a thermally conductive powder; and
agent B: a composition containing at least a curing accelerator.

3. The thermally conductive resin composition according to claim 1 or 2, wherein the component (A) is contained in an amount of 20 to 90 parts by mass with respect to a total of 100 parts by mass of the component (A) and the component (B).

4. The thermally conductive resin composition according to claim 1 or 2, wherein the component (D) is contained in an amount of 10 to 200 parts by mass with respect to a total of 100 parts by mass of the component (A) and the component (B).

5. The thermally conductive resin composition according to claim 1 or 2, wherein the component (D) is a polyether-based plasticizer.

6. A thermally conductive resin composition comprising components (A"), (B"), (C), and (E) below, wherein a tensile strength of a cured product is 0.40 MPa or more, and
an elongation percentage of a cured product is 60% to 1500%:
component (A"): urethane (meth)acrylate;
component (B"): a monofunctional (meth)acrylic monomer not having a urethane skeleton;
component (C): a radical polymerization initiator; and
component (E): a thermally conductive powder.

7. The thermally conductive resin composition according to claim 1, 2, or 6,
wherein the component (E) comprises:
(E1) a thermally conductive powder having an average particle diameter of 0.01 um or larger and smaller than 2.0 um;
(E2) a thermally conductive powder having an average particle diameter of 2.0 um or larger and smaller than 20 um; and
(E3) a thermally conductive powder having an average particle diameter of 20 um or larger and smaller than 150 um.

8. The thermally conductive resin composition according to claim 7, wherein the component (E) has a mass ratio (E1)/(E3) of 0.08 to 1.00 and a mass ratio (E2)/(E3) of 0.15 to 1.50.

9. The thermally conductive resin composition according to claim 1 or 2, wherein an elongation percentage of a cured product is 60% to 1500%.

10. A cured product obtained from the thermally conductive resin composition according to claim 1, 2, or 6.

11. An electronic component that dissipates heat through the thermally conductive resin composition according to claim 1, 2, or 6.
